Europäisches Patentamt

(19) European Patent Office

Office européen des brevets

(11) Publication number: **0 043 248**
**B1**

(12) **EUROPEAN PATENT SPECIFICATION**

(45) Date of publication of patent specification: **30.05.84**

(51) Int. Cl.³: **C 23 C 13/02, C-23 C 13/08**

(21) Application number: **81302876.8**

(22) Date of filing: **25.06.81**

(54) Process for the bulk production of alloys and apparatus therefor.

(30) Priority: **01.07.80 GB 8021446**

(43) Date of publication of application:
**06.01.82 Bulletin 82/01**

(45) Publication of the grant of the patent:
**30.05.84 Bulletin 84/22**

(84) Designated Contracting States:
**AT CH DE FR LI SE**

(56) References cited:
**GB-A-1 206 586**
**GB-A-1 364 960**
**GB-A-1 428 702**
**GB-A-1 428 703**
**GB-A-1 521 293**
**GB-A-1 529 418**

(73) Proprietor: **The Secretary of State for Defence in Her Britannic Majesty's Government of The United Kingdom of Great Britain and Northern Ireland Whitehall London SW1A 2HB (GB)**

(72) Inventor: **Bickerdike, Robert Lewis Clay's Farm East Worldham Alton Hampshire (GB)**

(74) Representative: **Miller, Ronald Anthony et al Procurement Executive, Ministry of Defence Patents 1A4, Room 2014 Empress State Building Lillie Road London SW6 1TR (GB)**

Courier Press, Leamington Spa, England.

## Description

The invention relates to an improved process for the production of bulk alloys in which the alloy is produced by deposition from the vapour phase of its constituent elements, and to apparatus for carrying out the aforesaid process.

Processes and apparatus for the production of bulk alloys by deposition of the constituents from the vapour phase onto a temperature controllable surface are known and examples of such processes and apparatus are described in UK Patent Specifications 1206586, 1265965 and 1521293. UKP 1206586 describes a collector which comprises a cylinder which is rapidly rotated over an array of vapour sources. UKP 1265965 describes apparatus where the collector is in the form of a rotatable circular plate which is positioned above one or more vapour sources. UKP 152 293 describes apparatus for in situ working by peening of the deposited alloy surface during the deposition process. The purpose of working being to obviate porosity developing in the alloy during deposition. Problems with this prior art stem from the fact that the processes and apparatus described are suitable only for the production of small quantities of material. For such a process to be economically and technologically viable it must be capable of producing large quantities of material having repeatable uniform properties.

A typical process for producing bulk alloy by deposition from the vapour phase comprises the following basic steps. A flat elongate temperature controllable collector is positioned above one or more heated sources from which the alloy constituents are evaporated. The collector is arranged to be able to traverse in a horizontal plane over the heated source(s) in a reciprocating motion so that it is alternately exposed to and removed from the vapour source. During the periods in which the collector is removed from the vapour source means are provided to work mechanically the surface of the deposited alloy, usually by a peening action, in order to remove porosity developing adjacent the surface and to renucleate the columnar grains. The collector, vapour source and mechanical working means are all housed within a vacuum or low pressure chamber. As the collector is repeatedly traversed above the vapour source(s) the deposit thickness thereon builds up incrementally and is principally dependent, for a given alloy system, on the vapour source temperature and area and on the total exposure time of the collector to the vapour. Once the required deposit thickness is obtained the collector may be removed from the vacuum chamber and the deposit separated from the collector.

The existing apparatus has been used for the production of relatively small quantities of bulk alloy suitable for further metallurgical processing into material from which various test pieces can be manufactured.

A problem with the existing apparatus is that it does not lend itself to the production of large pieces of alloy suitable, for example, for the manufacture of component parts of aircraft structures. A further disadvantage of the existing apparatus is that it is unsuitable for the high production rates which would be necessary to make this type of process economically feasible for the subsequent production of aircraft structure components manufactured from the alloy so produced.

It is envisaged that a production plant producing vapour deposited alloy on an industrial scale may require a continuous evaporative process sustained for up to 100 hours. If apparatus of the present type were scaled up to be able to operate for such a period it is estimated that the reciprocating type of collector would need to be approximately 10 m long and the vacuum chamber housing it at least twice this length. The problems inherent, if such a scaling up route were to be adopted, are not only limited to engineering problems but also have serious consequences for the metallurgical criteria required for the production of the alloy itself. For example it is necessary to maintain the vacuum chamber at an extremely low pressure to satisfy the metallurgical requirement of low oxidation of the deposited alloy surface, which presents formidable engineering problems in pumping down such a large chamber and maintaining the vacuum generated within a realistic time period. A further engineering problem with possible detrimental metallurgical consequences is that of the forces necessary in arresting and accelerating the collector/deposit mass during reciprocating motion, it would not be feasible merely to slow down the traverse speed to reduce the forces as this would lead to unacceptable heating of the deposit surface by the impinging vapour resulting in growth of dispersed hardening phases with consequent irreversible degradation of the alloy properties. An additional problem which could result from a low traverse speed is that of contamination or oxidation of the deposited alloy surface resulting from the increased time available for chemical reaction in the period between each increment resulting in laminar weaknesses in the bulk alloy. It will be appreciated that this particular problem will be exacerbated by the difficulties involved in an apparatus described in the known art of pumping down such a large vacuum chamber and of monitoring any localised leaks in, for example, coolant circuits lying close to the collector surface, within the vacuum chamber.

According to a first aspect of the present invention a process for the production of a multiphase alloy in bulk form comprises the steps of producing the alloy constituents in vapour form from at least one evaporating source in a low pressure environment and characterised by depositing the alloy vapour onto the outer curved surface of a rotating temperature controlled cylindrical collector and also mechanically working the surface of the deposited alloy during the deposition process.

Alloys for which the vapour deposition route is ideally suited are those alloys which are known to form metastable phases but which cannot be produced in the metastable form by the conventional metallurgical processes of melting and casting with subsequent heat treatment. By the vapour deposition route alloys may be formed which contain greater quantities of hardening phases than would be indicated by reference to the relevant phase equilibrium diagram for the alloy system in question. Moreover, the hardening phase can be produced as a uniform dispersion of fine particles which are retained in the metastable form.

Typical of the alloy systems for which the vapour deposition process is particularly suited is the Aluminium-Chromium-Iron system (which has been described in UK Patent Specification 1,447,224). As an example an alloy with an aluminium matrix and containing by weight 8% chromium and 1.3% iron has been produced by this process where the two principal alloying elements are contained both in solid solution and as a uniform dispersion of fine intermetallic particles typically of a size around 5 nanometres. The direct benefits of being able to produce an aluminium alloy with such a high proportion of fine, uniformly dispersed hardening phases are improvements in tensile and proof strength of 50% and in creep, fatigue and corrosion resistance of the order of 100% when compared with conventional high strength aluminium alloys (containing alloying additions of Zn, Cu, Mg for example) produced by melting and casting with subsequent solution and precipitation heat treatments.

Because the hardening phases in the Aluminium-Chromium-Iron system are produced and retained in the metastable form there are temperature limits above which the alloy so produced should not be heated in order to prevent the nucleation and growth of large particles which would have detrimental effects on both the mechanical and corrosion resistant properties of the alloy. Due to both the metallurgical criteria which must be satisfied when producing the alloy and the economic criteria which also must be borne in mind for any production process the rotating drum collector has several particular advantages which contribute towards both sets of criteria.

According to a second aspect of the present invention apparatus for the production of a multi-phase alloy in bulk form comprises a main low pressure chamber, a rotatable cylindrical drum having a temperature controllable cylindrical collector surface at least one evaporating source positioned below the collector, the evaporating source comprising a crucible and means for melting the metal contained therein and maintaining the molten metal at a predetermined temperature and characterised by a feed crucible for maintaining a substantially constant level and composition of metal in the evaporating source crucible, the feed crucible having means for melting and degassing metal contained therein, and mechanical working means in the main chamber for mechanically working the surface of the deposited alloy during the deposition processes.

Advantages conferred by the process and apparatus of the present invention are:

(i) that for a given collector area the total process apparatus can be housed within a smaller volume of vacuum chamber. This reduces both the time to pump down and the engineering difficulties involved with maintaining the chamber at a pressure of typically $4 \times 10^{-5}$ torr;

(ii) that the engineering problems of driving a rotating drum collector at a substantially constant speed of, for example, 10 revolutions per minute are insignificant compared to the inherent inertia problems of a reciprocating collector being driven at a speed high enough to maintain the deposited alloy surface at a temperature low enough to prevent harmful large particle nucleation and growth;

(iii) that the speed of the rotating drum collector can be readily varied so that the time period between deposit increments at each revolution can be kept sufficiently short to limit the formation of oxide layers on the deposit surface due to residual oxygen and water vapour in the apparatus;

(iv) that since a surface of uniformly constant geometry and rotational direction and velocity are presented to the evaporating source the deposit produced is of much improved uniformity of section compared to a reciprocating collector, which enables a substantially higher deposit utilisation;

(v) that for a given allowable temperature increase above the evaporator, because of the higher speed of the deposit past the evaporator a higher deposition rate can be achieved by utilising a higher evaporation rate.

In a preferred embodiment of the invention the method of temperature control of the outer curved periphery of the collector drum is by means of gas-gap cooling assemblies which rely on the heat conduction properties of a gas or other fluid forced between the cooling assembly and the inner curved surface of the drum. Alternatively more conventional cooling means may be provided by fluid channels arranged in thermal contact with the collector inner surface.

A further feature of the invention is the provision of additional auxiliary vacuum chambers wherein feed stock alloy may be melted and degassed without contaminating the primary vacuum chamber which houses the collector. Having auxiliary melting/degassing vacuum chambers allows for the provision of a continuous deposition process without the risk of the deposit on the collector being physically contaminated by metal splashes caused by outgassing of metal in the evaporator crucible. In order to guard against the possibility of metal splashes on the collector during melting and degassing of the initial start charge of metal in the evaporator crucible, a removable shutter is interposed between the collector and evaporator crucible during the melting and degassing stage prior to the start of the deposition process. Once the metal in the auxiliary vacuum chambers has been melted and degassed it may be transferred as a continuous stream to the evaporator crucible to maintain a substantially constant metal level within the crucible.

Preferably the distance between the metal level in the evaporator crucible and the deposit surface on the collector should be maintained constant. To achieve this the evaporator crucible may be mounted on adjustable height means which are controlled automatically by sensing apparatus to maintain a substantially constant metal level/deposit surface distance.

In order that the invention be more fully understood a preferred embodiment will be described by way of example only with reference to:

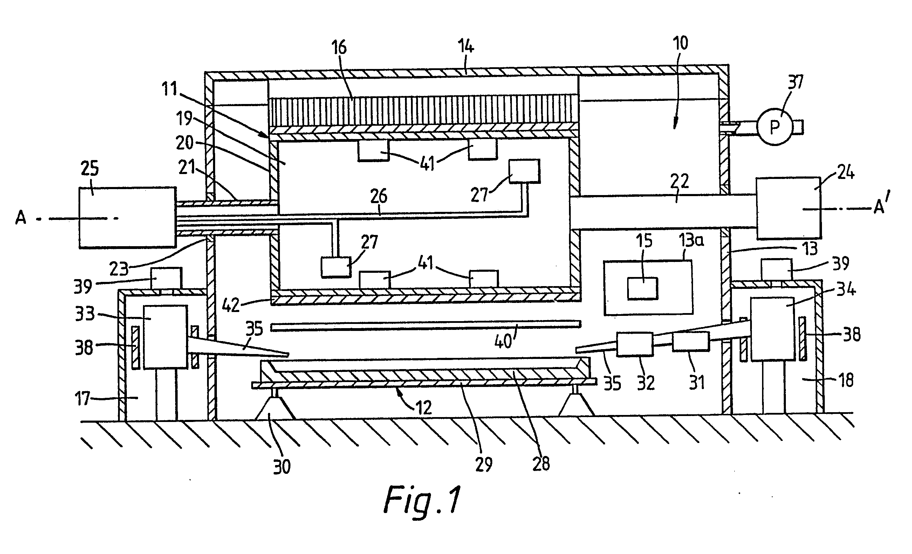

Figure 1 which is a schematic representation of the front elevation of the proposed invention sectioned diametrally through the collector drum, the rotational axis of which lies on the line A—A'.

Referring to Figure 1 the apparatus comprises a vacuum chamber 10 having housed therein a drum assembly 11 on which is deposited vapour of the required alloy composition evaporated from an evaporated source 12.

The chamber 10 comprises a base member 13 and a removable roof section 14. Both the base member 13 and the roof section 14 are coated with lead (not shown). The base member 13 has a window 13a incorporating probes 15 for the monitoring and measurement of the alloy deposit thickness. A surface peening device 16 forms part of the removable roof section 14 of the vacuum chamber 10. The vacuum chamber 10 also includes additional auxiliary vacuum chambers 17 and 18 which can be evacuated and sealed independently of the main vacuum chamber 10.

The peening device 16 comprises a central shaft around which are arrayed four equispaced spindles at 90° intervals such that all five axes are parallel. Swingably mounted on the said four spindles are flails formed from a hard material such as tungsten carbide, each flail being separated by a spacer. The peening device has drive means to rotate the assembly about the axis of the central shaft and thus cause the flail heads to strike the surface of the deposit passing beneath on a collector 19 forming part of the drum assembly 11. Because the peening device operates in an elevated temperature environment provision is made for water-cooling via internal passages in the central shaft. The base member 13 and the roof section 14 are sealable to each other to enable the chamber 10 to be evacuated by a conventional vacuum pump 37.

The drum assembly 11 includes the cylindrical collector 19 formed from a centrifugally cast pipe which has been machined on the inner surface and abraded on the outer surface. The collector 19 is supported on a pair of flanged ends 20 which also include vacuum tight seals (not shown). The flanged ends 20 are coupled to hollow and solid stub shafts 21 and 22 respectively which are rotatable within bearings assemblies 23 which incorporate vacuum tight seals (not shown). The bearing assemblies 23 are housed in the base member 13.

The drum assembly 11 is connected at one end by the solid stub shaft 22 to a drive unit 24 which incorporates speed control means (not shown) to rotate the drum assembly 11. The hollow stub shaft 21 links the other end of the drum assembly 11 to a temperature control unit 25. The temperature control unit 25 operates by supplying electrical power to heaters 41 attached to the inner surface of the collector 19 for initial heating of the collector 19 prior to start-up and by delivering cooling fluid to the gas-gap cooling assemblies 27 during the deposition process.

The cooling fluid is delivered to the inner surface of the collector 19 by means of pipes 26 which lead to gas-gap cooling assemblies 27. In operation the cooling assemblies 27 are in heat exchange contact with the inner surface of the collector 19 through the medium of helium gas introduced into the drum assembly 11 during the deposition process, the cooling rate being dependent upon the helium gas pressure.

The evaporating source 12 includes an evaporating crucible 28 positioned below the drum assembly 11, the evaporating crucible 28 extends over the full length of the collector 19. The evaporating crucible 28 is mounted on a platform 29 which is itself supported on adjustable height jacks 30. The height of the evaporating crucible 28 is adjusted during the deposition process to maintain a substantially constant distance between the metal level in the evaporating crucible 28 and the surface of the deposited alloy on the collector 19. Adjustment is effected automatically in response to signals from the probes 15. Interposed between the evaporating source 12 and the collector 19 is a shutter 40 which can be withdrawn from between the evaporating source 12 and the collector 19 by a handle (not shown) in the base

member 13 of the vacuum chamber 10. Remotely positioned from the evaporating crucible 28 is an electron beam gun 31 the beam arranged to scan the said surface at high speed by means of electromagnetic deflecting coils 32.

To maintain continuity of operation the evaporating crucible 28 is fed in turn from a first-feed-crucible 33 and a second-feed-crucible 34 which are housed in auxiliary vacuum chambers 17 and 18 respectively. The auxiliary vacuum chambers include metal melting and degassing equipment 38 and 39 respectively, such that metal can be melted and degassed before it is fed from the crucibles 33 and 34 into the evaporating crucible 28 via the feed channels 35.

To prepare the apparatus for operation the roof section 14 is removed from the base member 13 to allow the collector 19 to be lowered into a position within the base member 13 so that the heaters 41, cooling assemblies 27 and feed pipes 19 may be installed within the collector 19. Thereafter the flanged ends 20 may be sealably coupled to the collector 19. The crucibles 33 and 34 are charged with metal and the melting and degassing cycle commenced.

The evaporating crucible 28 is charged with metal of a suitable composition to provide vapour of the required composition at the evaporating process temperature. Once the drum assembly 11 has been installed the roof section 14 is replaced and evacuation of the vacuum chamber 10 begun. When the vacuum chamber 10 is at the required low pressure the shutter 40 is interposed between the evaporating crucible 28 and the collector 19 and melting and degassing of the charge of metal in the evaporating crucible 28 commenced by activating the electron-beam gun 31 and deflecting the electron beam to scan the metal surface by use of the electromagnetic coils 32. The collector 19 is preheated by the electrical heaters 41 to the required temperature of 250°C for good adhesion of the deposit 42 during the initial stages of vapour deposition.

Once the metal in the evaporating crucible 28 and the collector 19 are at the required temperature the drive unit 24 is started to rotate the collector 19 at the required speed and the shutter 40 is withdrawn from between the collector 19 and the evaporating source 28 to allow the alloy vapour to deposit on the collector 19. The melted and degassed alloy in the feed crucible 33 is fed to the evaporating crucible 28 via the respective feed channel 35 to a predetermined level. As the collector 19 rotates the surface of the deposit 42 is peened by the peening device 16 in order to improve the micro-structure of the deposit.

During the process the level of metal in the evaporating crucible is maintained at a constant level by controlling the rate of supply of metal from the crucible 33. When the supply of molten metal from the crucible 33 is exhausted the metal feed to the evaporating crucible 28 is assumed by the crucible 34 via its feed channel 35. The exhausted crucible 33 may then be recharged with fresh metal which is then melted and degassed within the confines of the auxiliary vacuum chamber 17.

Heat which is generated during the process is removed from the collector 19 by supplying cooling fluid to the gas-gap cooling assemblies 27. The rate of heat transfer from the collector 19 to the gas-gap cooling assemblies is controlled by adjusting the pressure of helium gas within the collector 19.

When the process has been completed the vacuum chamber 10 and the drum assembly 11 is dismantled and the collector/deposit 19/42 raised from the base member 13. After removal the collector 19 is machined from the deposit using a boring tool. The deposit 42 may be cut as required or may be formed into sheet using flattening and rolling techniques.

In an alternative embodiment the collector may be formed from a series of arcuate plates clamped around the periphery of a drum permanently installed within the vacuum chamber. The plates being removable after appropriate machining of the deposit. This method of forming the collector has the advantages that there would be no need to connect and disconnect the drive and cooling facilities at the start and end of each deposition run and also that the arcuate plates could be formed from previously produced deposit thus obviating the need to machine the "collector" from the deposit.

The deposition process may be made wholly continuous by using two collectors each mounted in independent deposition chambers. The evaporators in each of the deposition chambers are linked to auxiliary chambers, as described, such that one deposition chamber may be prepared while the evaporator in the other chamber is supplied with molten alloy.

Because of the differing vapour pressures of the alloy constituents at the evaporating temperature it is necessary that the composition of the metal in the evaporating crucible start charge is chosen to produce the required alloy composition deposited on the collector. To generate a metal vapour of the required composition, for example 1.3% by weight iron, 8% by weight chromium and balance aluminium, the composition of the start charge is required to be approximately 20% by weight iron, 20% by weight chromium and balance aluminium. It will be appreciated that as the deposition process proceeds the remaining metal in the evaporating crucible becomes progressively depleted in aluminium as this constituent is being evaporated off more rapidly. To control the metal in the evaporating crucible at a substantially constant composition it is necessary to supply it with metal of substantially the same composition as the vapour being evaporated off that is 1.3% by weight Fe, 8% by weight Cr, balance Al, at substantially the same rate.

## Claims

1. A process for the production of a multi-phase alloy in bulk form comprises the steps of producing the alloy constituents in vapour form from at least one evaporating source (12) in a low pressure environment (10) and characterised by depositing the alloy vapour onto the outer curved surface of a rotating temperature-controlled cylindrical collector (19) and also mechnically working the surface of the deposited alloy (42) during the deposition process.

2. A process as claimed in claim 1 characterised in that the surface of the deposited alloy (42) is mechanically worked by a peening action during the deposition process.

3. A process as claimed in claim 1 characterised by maintaining a substantially constant level and composition of metal in the evaporating source crucible (28) during the deposition process by furnishing replacement molten metal of the correct composition from at least one remotely sited feed source (33) and the replacement molten metal having first been melted and degassed remote from the deposited alloy (42) to prevent contamination of the deposit surface.

4. A process as claimed in claim 1 and characterised in that the temperature controllable collector (19) is formed from a non-reusable cylindrical pipe which is removable from the deposited alloy (42) by a machining process subsequent to deposition.

5. A process as claimed in claim 1 characterised in that the deposited alloy comprises 8% by weight of chromium, 1.3% by weight of iron, the balance being aluminium apart from minor proportions of impurities and where the two principal alloying elements are contained both in solid solution and as a uniform dispersion of fine intermetallic particles typically of a size around 5 nanometres.

6. Apparatus for the production of a multi-phase alloy in bulk form comprises a main low pressure chamber (10), a rotatable cylindrical drum having a temperature controllable cylindrical collector surface (19), at least one evaporating source (12) positioned below the collector, the evaporating source comprising a crucible (28) and means (31, 32) for melting the metal contained therein and maintaining the molten metal at a predetermined temperature and characterised by a feed crucible (33) for maintaining a substantially constant level and composition of metal in the evaporating source crucible (28), the feed crucible (33) having means for melting (38) and degassing (39) metal contained therein, and mechanical working means (16) in the main chamber (10) for mechanically working the surface of the deposited alloy (42) during the deposition process.

7. An apparatus as claimed in claim 6 characterised by an auxiliary low pressure chamber (17) housing the feed crucible (33) means in the auxiliary low pressure chamber (17) for melting (38) and degassing (39) the metal to be supplied to the evaporating source crucible (28).

8. An apparatus as claimed in claim 6 characterised by the temperature controllable collector (19) having heaters (41) for initially heating the collector surface and coolers (27) for cooling the collector surface during the deposition process.

9. An apparatus as claimed in claim 6 characterised in that the collector (19) has a hollow interior isolated from the main chamber (10) and has gas-gap coolers (27).

10. An apparatus as claimed in claim 6 characterised in that the surface of the collector (19) is formed by arcuate plates affixable to a temperature controllable cylindrical drum and that the arcuate plates are removable from the collector drum after deposition of alloy from the vapour phase by suitable machining of the alloy deposit (42).

## Patentansprüche

1. Verfahren zur Erzeugung einer Vielphasenlegierung in Massenform umfaßt die Schritte des Erzeugens der Legierungsbestandteile in Dampfform aus wenigstens einer Verdampfungsquelle (12) in einer Niedrigdruckumgebung und ist gekennzeichnet durch Abscheiden des Legierungsdampfes auf die äußere gekrümmte Oberfläche eines rotierenden, temperaturgesteuerten, zylindrischen Kollektors (19) und auch durch mechanische Verformung der Oberfläche der abgeschiedenen Legierung (42) während des Abscheideprozesses.

2. Verfahren nach Anspruch 1, dadurch gekennzeichnet, daß die Oberfläche der abgeschiedenen Legierung (42) durch eine Hämmerwirkung während des Abscheideprozesses mechanisch verformt wird.

3. Verfahren nach Anspruch 1, dadurch gekennzeichnet, daß man Niveau und Zusammensetzung des Metalls im Verdampfungsquellentiegel (28) während des Abscheideprozesses im wesentlichen konstant hält, indem man Ersatzmetallschmelze der richtigen Zusammensetzung von wenigstens einer entfernt liegenden Nachschubquelle (3) zuführt, wobei die Ersatzmetallschmelze zunächst entfernt von der abgeschiedenen Legierung (42) geschmolzen und entgast wurde, um Verschmutzung der Abscheideoberfläche zur verhindern.

4. Verfahren nach Anspruch 1, dadurch gekennzeichnet, daß der temperatursteuerbare Kollektor (19) aus einem nichtwiederverwendbaren zylindrischen Rohr gebildet wird, das von der abgeschiedenen Leigierung (42) durch einen Bearbeitungsprozeß nach der Abscheidung entfernbar ist.

5. Verfahren nach Anspruch 1, dadurch gekennzeichnet, daß die abgeschiedene Legierung 8 Gewichtsprozent Chrom, 1,3 Gewichtsprozent Eisen, Rest Aluminium außer geringen Anteilen von Verunreinigungen enthält, wobei die zwei Hauptlegierungselemente sowohl als Mischkristalle als auch als gleichmäßige Dispersion feiner intermetallischer Teilchen mit einer Abmessung von typisch etwa 5 nm vorliegen.

6. Vorrichtung zur Erzeugung einer Vielphasenlegierung in Massenform weist eine Hauptniederdruckkammer (10), eine drehbare zylindrische Trommel mit einer temperatursteuerbaren zylindrischen Kollektoroberfläche (19), wenigstens eine unterhalb des Kollektors angeordnete Verdampfungsquelle (12) auf, die einen Tigel (28) und Mittel (31 32) zum Schmelzen des darin enthaltenen Metalls und Halten der Metallschmelze auf einer vorbestimmten Temperatur enthält, und ist gekennzeichnet durch einen Nachschubtiegel (33) zum wesentlichen Konstanthalten des Niveaus und der Zusammensetzung des Metalls im Verdampfungsquellentiegel (28), wobei der Nachschubtiegel (33) Mittel zum Schmelzen (38) und Entgasen (39) des darin enthaltenen Metalls aufweist, und mechanisch Verformungsmittel (16) in der Hauptkammer (10) zum mechanischen Verformen der Oberfläche der abgeschiedenen Leigierung (42) während des Abscheideprozesses.

7. Vorrichtung nach Anspruch 6, gekennzeichnet durch eine den Nachschubtiegel (33) aufnehmende Hilfsniederdruckkammer (17), Mittel in der Hilfsniederdruckkammer (17) zum Schmelzen (38) und Entgasen (39) des zum Verdampfungsquellentiegel (28) zuzuführenden Metalls.

8. Vorrichtung nach Anspruch 6, dadurch gekennzeichnet, daß der temperatursteuerbare Kollektor (19) Heizer (41) zum anfänglichen Erhitzen der Kollektoroberfläche und Kühler (27) zum Kühlen der Kollektoroberfläche während des Abscheideprozesses aufweist.

9. Vorrichtung nach Anspruch 6, dadurch gekennzeichnet, daß der Kollektor (19) ein von der Hauptkammer (10) isoliertes hohles Inneres aufweist und Gas-Spalt-Kühler (27) hat.

10. Vorrichtung nach Anspruch 6, dadurch gekennzeichnet, daß die Oberfläche des Kollektors (19) durch gewölbte Platten gebildet ist, die an einer temperatursteuerbaren zylindrischen Trommel befestigbar sind, und daß die gewölbten Platten von der Kollektortrommel nach Abscheidung der Legierung aus der Dampfphase durch geeignete Bearbeitung der Legierungsabscheidung entfernbar sind.

## Revendications

1. Procédé pour la production d'un alliage polyphasé en masse incluant les phases opératoires consistant à produire les constituants de l'alliage sous la forme d'une vapeur à partir d'au moins une source d'évaporation (12) dans un environnement à basse pression (10), caractérisé par le dépôt de la vapeur de l'alliage sur la surface extérieure courbe d'un collecteur cylindrique tournant (19) dont la température est réglée, et également par un traitement mécanique de la surface de l'alliage déposé (42), pendant le processus de dépôt.

2. Procédé selon la revendication 1, caractérisé en ce qu'on traite mécaniquement la surface de l'alliage déposé (42) au moyen d'un action de courbe pendant le processus de dépôt.

3. Procédé selon la revendication 1, caractérisé par le fait qu'on maintient un niveau et une composition du métal, essentiellement constants, dans le creuset (28) de la source d'évaporation pendant le processus de dépôt au moyen d'un apport d'un métal fondu de remplacement possédant la composition correcte à partir d'au moins une source d'alimentation (33) située à distance, le métal fondu de remplacement ayant été tout d'abord fondu et dégazé à distance de l'alliage (42) déposé, afin d'empêcher une pollution de la surface du dépôt.

4. Procédé selon la revendication 1, caractérisé en ce que le collecteur (19), dont la température peut être commandée est formé à partir d'un tube cylindrique non réutilisable, qui peut être retiré de l'alliage déposé (42) grâce à un processus d'usinage intervenant après le dépôt.

5. Procédé selon la revendication 1, caractérisé en ce que l'alliage déposé comporte 8% en poids de chrome, 1,3% en poids de fer, le reste étant constitué par de l'aluminium en dehors de quelques pourcentages mineurs d'impuretés, deux éléments principaux entrant dans la composition de l'alliage étant contenus à la fois dans une solution solide et en tant que dispersion uniforme de fines particules intermétalliques possédant de façon typique une taille d'environ 5 nanomètres.

6. Appareil pour la production d'un alliage polyphasé en masse, comprenant une enceinte à basse pression (10), un tampon cylindrique rotatif possédant une surface cylindrique de collecteur (19), dont la température peut être réglée, au moins une source d'évaporation (12) disposée au-dessous du collecteur comportant un creuset (28), des moyens (31, 32) servant à faire fondre le métal qui s'y trouve contenu et à maintenir le métal fondu à une température prédéterminée, caractérisé par le fait qu'il comporte un creuset d'alimentation (33) servant à maintenir un niveau et une composition du métal, essentiellement constants, dans le creuset (28) de la source d'alimentation, et comportant des moyens (38) pour faire fondre et des moyens (39) pour dégazer le métal qui s'y trouve contenu, et des moyens de travail mécaniques (16) situés dans l'enceinte principale (10) et servant à traiter mécaniquement la surface de l'alliage déposé (42), pendant le processus de dépôt.

7. Appareil selon la revendication 6, caractérisé en ce qu'il comporte une enceinte auxiliaire à basse pression (17) logeant le creuset d'alimentation (33), et des moyens situés dans l'enceinte auxiliaire à basse pression (17) pour fondre (38) et dégazer (39) le métal devant être envoyé au creuset (28) de la source d'évaporation.

8. Appareil selon la revendication 6, caractérisé par le fait qu'il comporte un collecteur (19), dont la température peut être réglée et qui comporte des dispositifs de chauffage (41) servant à réaliser le chauffage initial de la surface du collecteur, et des dispositifs de refroidissement (27) servant à refroidir la surface du collecteur pendant le processus de dépôt.

9. Appareil selon la revendication 6, caractérisé en ce que le collecteur (19) comporte un espace intérieur creux isolé par rapport à l'enceinte principale (10), et des dispositifs de refroidissement (27) à interstice à gaz.

10. Appareil selon la revendication 6, caractérisé en ce que la surface du collecteur (19) est formée par des plaques courbes pouvant être fixées à un tambour cylindrique, dont la température peut être réglée, et que les plaques courbes peuvent être retirées du tambour à collecteur après le dépôt de l'alliage à partir de la phase vapeur, grâce à un usinage approprié du dépôt d'alliage (42).

*Fig.1*